# EUROPEAN PATENT APPLICATION

(11) **EP 2 149 989 A1**
(43) Date of publication of application: **03.02.2010**
(21) Application number: 08305443.7
(22) Date of filing: 01.08.2008
(51) Int. Cl.: H03K 19/003, H03F 3/45, H01L 27/02

(54) **Integrated circuit**

(71) Applicant: Alcatel Lucent, 75008 Paris (FR)
(72) Inventor: Conrad, Henry, 71701, Schwieberdingen (DE)
(74) Representative: Urlichs, Stefan

(57) **Abstract**

In order to compensate for bit pattern effects, an integrated circuit contains a first transistors (Q1A) for use as signal transistor and a second transistor (Q1B) integrated with the first transistor (Q1A) for use as a temperature measure device. The two transistors (Q1A, Q1B) share either the same collector or the same emitter but have mutually isolated base connections. A circuit arrangement encompassing such integrated circuit contains a thermal offset control loop (OA1) which is connected to the second transistor (Q1B). The thermal offset control loop (OA1) is arranged to compensate at an input of first transistor (Q1A) for temperature induced voltage changes at an output of the second transistor (Q1B).

## Description

### Field of the Invention

The present invention relates to the field of electronics and more particularly to an circuit and a method for compensating temperature induce voltage changes in a signal transistor.

### Background of the Invention

In modern telecommunications, integrated circuits are used such as data receivers, power amplifiers and analog-digital converters. Such integrated circuit are often implemented in bipolar or BiCMOS technology, which are prone to thermal effects.

Power MOS transistors or power IGBTs, which have monolithically integrated measurement diodes for temperature sensing are known from US 5,237,481 and US 5,049,961.

### Summary of the Invention

We have observed, that an integrated circuit, which is used as receiver for data signals in an optical data transmission system, shows unexpected degradation of the input sensitivity. By use of differentiating measurement methods we found, that the input sensitivity of the examined receiver was depending of the received bit pattern. We could show that the observed loss of sensitivity has its root cause in the different self heating of integrated transistors.

It is therefore an object of the present invention to provide an integrated circuit which is less sensitive to bit pattern effects and a corresponding method of compensating for bit pattern effects.

These and other objects that appear below are achieved by an integrated circuit which contains a first transistors for use as signal transistor and a second transistor integrated with the first transistor for use as a temperature measure device. The two transistors share either the same collector or the same emitter but have mutually isolated base connections.

A circuit arrangement encompassing such integrated circuit contains a thermal offset control loop which is connected to the second transistor. The thermal offset control loop is arranged to compensate at an input of first transistor for temperature induced voltage changes at an output of the second transistor.

According to another aspect, a method for compensating temperature induced voltage changes in a signal transistor contains the steps of:
- providing a measurement transistor integrated with said signal transistor;
- providing a voltage drop at said measurement transistor as input to a thermal offset control loop; and
- providing a correction signal by said thermal offset control loop to compensate a voltage change in a signal passing through said signal transistor (Q1A) for a temperature induced voltage change at said measurement transistor.

The embedding of a measurement transistor with a signal transistor allows for exact measurement of the core temperature in the signal transistor. With the knowledge of the core temperature current sensitivity limitations can be overcome.

Good sensitivity is an important unique selling point and ensures an advantage in competition. The invention is particularly useful in differential circuits where two differential circuit branches can show different local temperatures, which leads to a temperature-induced voltage difference.

### Brief Description of the Drawings

Preferred embodiments of the present invention will now be described with reference to the accompanying drawings in which
- figure 1: shows a cross section of a conventional bipolar transistor with deep trench isolation;
- figure 2: shows a differential amplifier, which shows bit pattern effects;
- figure 3: shows a multi-terminal transistor with integrated sensing diode according to the present invention;
- figure 4: shows an integrated differential amplifier using the transistor of figure 3; and
- Figure 5: shows a thermal offset compensation loop in a two stage differential amplifier.

### Detailed Description of the Invention

It is understood that the pattern effect observed has its root cause in the local thermal heating of the transistors involved.

Bipolar transistors in modern Bipolar/BiCMOS technologies are reduced in size to keep parasitic elements small to be able to achieve highest operating frequencies. Typical transistors in modern technologies use an area of about 4 µm * 4 µm. Furthermore these high frequency transistors require a high current density to operate in the optimum operating point. This leads to an increase of local power distribution which we call hot spots. The self heating of bipolar transistors is increased when they are surrounded by a Deep Trench Frame for better electrical decoupling. This frame made from silicon dioxide is built-in 6-10 µm around the diffusion area of the transistor. Since silicon dioxide has low thermal conductivity, transistors with deep trench have an increased thermal resistance.

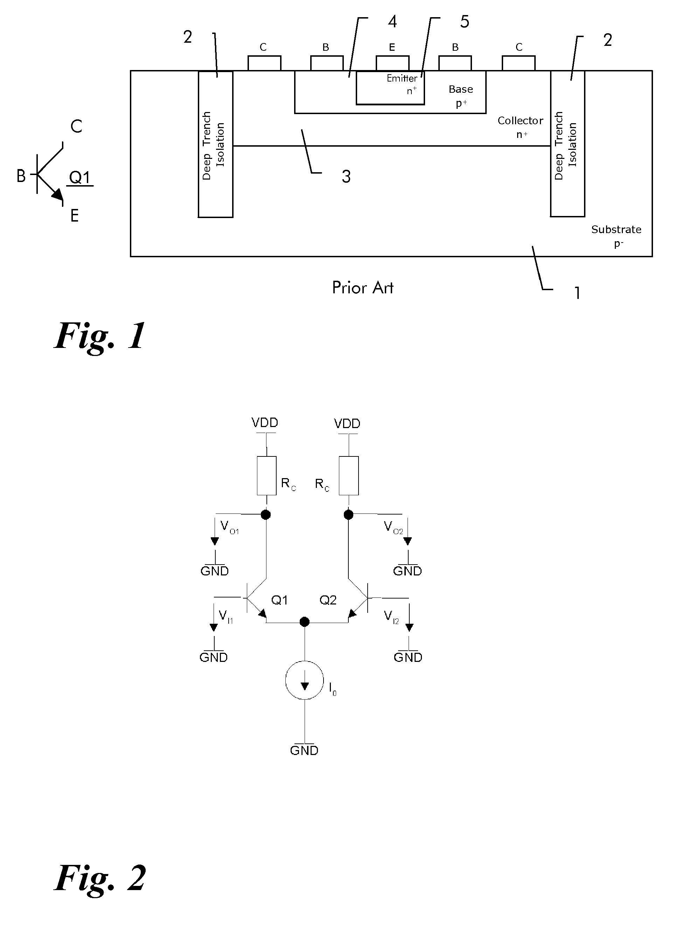

Figure 1 shows a cross section of a conventional bipolar transistor with deep trench isolation. The transistor Q1 is arranged on a p⁻ doped semiconductor substrate 1 within a deep trench frame 2 made of silica. Between the silica isolation 2 is a n⁺ doped area 3, which acts as collector C. In the center of the collector area 3 is a p⁺ doped area 4, which forms the base terminal B of the transistor. Again in the center of the base area 4 is the n⁺ doped emitter (E) area 5.

In the following, the invention will be explained by way of a differential amplifier. The invention can, however, also be applied in other kind of integrated circuits.

A basic differential amplifier is shown in figure 2. It contains a pair of emitter coupled transistors Q1, Q2. A differential input voltage V_{I1}, V_{I2} is supplied to the base terminals of the two transistors Q1, Q2. The collectors of the transistors Q1, Q2 are connected via respective resistors R_{C} to a voltage supply VDD. The coupled emitters are connected via a constant current source I₀ to ground level GND. The voltage drop between the ground level GND and collectors of the two transistors Q1, Q2 forms the differential output voltage signal V_{O1}, V_{O2}.

We have found out that in this basic amplifier configuration, an observed loss of sensitivity can be brought back to an offset at the input of the circuit, which has its root cause in the different self heating of the transistors Q1 and Q2 in the amplifier.

In the measured circuit we could show that offset is pattern dependant. This can be explained as follows: Assume the circuit is receiving a long logical "1" at the base of Q1. Long means the logical "1" is longer than the thermal time constant of the bipolar transistor Q1. The time constants in the current technology is τ < 0,1 µs. Q1 will carry the current I₀ of the current source and as a consequence dissipate power, which results in self heating. Q2 instead carries no current and will cool down to substrate temperature. Depending on the power dissipation of the amplifier stage, the temperature differences of such a differential pair can be 10K and more. The temperature gradient of the base emitter voltage is -1.3 mV/K. A temperature difference of 10K leads to an expected input offset of 13 mV. If after the long logical "1" one single "0" is received, the transistors still have the same temperature difference due to the long thermal time constant. In order to bring this "0" to the output of the stage, the thermal input voltage must be overcome. The thermal input voltage correspond to the observed loss in input sensitivity.

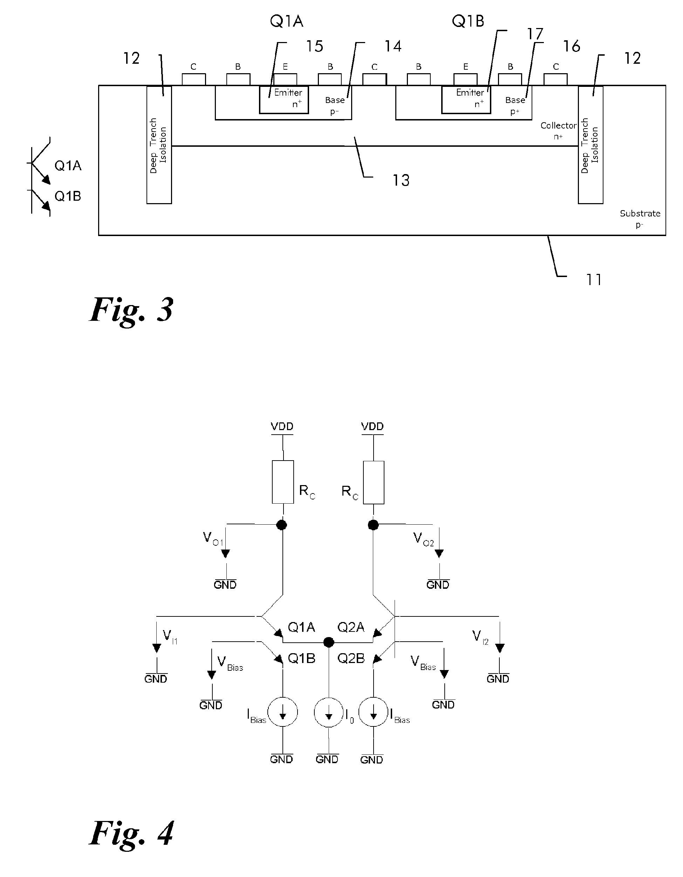

In order to be able to compensate for the thermal offset, a method must be found to measure the offset. Sensors placed along the switching transistors are not able to determine the temperature of the switching transistor exactly because the temperature at the sensor is overlaid by other temperature sources. The temperature measurement becomes more accurate if it possible to make the sensor part of the switching device - thus integrated within the deep trench frame. The cross section of such a device is shown in figure 3.

On the substrate 11, two transistors Q1A and Q1 B are realized within the deep trench frame 12. Q1A and Q1 B share the same collector 13 but have isolated base connections 14, 16 and emitter connections 15, 17.

Within a differential amplifier circuit as shown in figure 4, Q1A is taking over the switching function, whereas Q1 B serves as temperature measurement diode. The same applies for the transistor Q2A and Q2B of the differential stage. This leads to the circuit shown in figure 4.

Each of the temperature diodes Q1 B and Q2B carry a bias current I_{Bias}. I_{Bias} is very low so that self heating of Q1 B and Q2B can be neglected. The bases of Q1 B and Q2B are connected to V_{bias}. Doing so the Base-Emitter voltages of the transistors Q1 B and Q2B are only dependant of the local temperature. The difference of these voltages is thus used as control variable.

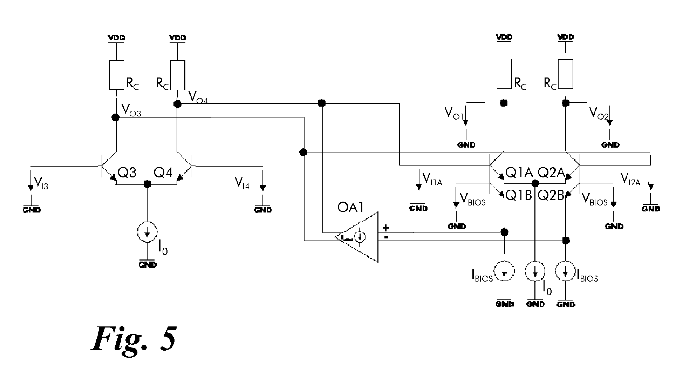

An example of a control loop utilizing the voltage difference is shown in figure 5. The circuit shown there is a two-stage differential amplifier. A first stage of emitter coupled transistors Q3, Q4 has the structure shown in figure 2. The differential output voltage V_{03,} V₀₄ of this first amplifier stage is fed as input V_{I1A}, V_{I2A} of a second amplifier stage of the type shown in figure 4.

The thermal offset control loop for differential amplifiers uses an operational amplifier OA1 which has high ohmic differential input and a differential current source output. The maximum current of this current source output is limited to about I₀/10. The total amplification is 1 to the differential input of OA1 to bases of Q1A, Q1 B. In case Q1A carries more current than Q2A, Q1A as a consequence will become warmer than Q2A which in turn leads to a positive offset at the input of OA1. The output current of OA1 is added to the currents of Q3 and Q4 generating an offset at the resistors R_{C}. Since the loop gain is 1, the offset, which is applied at the bases of the transistors Q1A and Q2A, is the thermal offset detected by the transistors Q1B and Q2B.

Having described a preferred embodiment of the invention, it should be understood that various modifications can be made, which would be apparent to those skilled in the art. Other kind of control loops are possible, for instance, to adjust the operating point of the transistors in the signal path to compensate for thermal effects detected by the integrated measurement transistor. In the embodiment, the transistors are of npn type. It should be clear that other types such as pnp are suitable as well and that instead of a shared collector, signal and measurement transistors can have a shared emitter.

## Claims

1. A circuit arrangement comprising an integrated circuit, the integrated circuit comprises a first transistors (Q1A) for use as signal transistor and a second transistor (Q1B) integrated with said first transistor (Q1A) for use as a temperature measure device; wherein the two transistors (Q1A, Q1B) share either the same collector (C1, C2) or the same emitter (E1, E2) but have isolated base connections (B1, B2); the circuit arrangement further comprising a thermal offset control loop (OA1) connected to said second transistor (Q1B), said thermal offset control loop being adapted to compensate at an input of first transistor (Q1A) for temperature induced voltage changes at an output of said second transistor (Q1B).

2. A circuit according to claim 1, wherein said integrated circuit further comprises a third transistors (Q2A) for use as signal transistor and a fourth transistor (Q2B) integrated with said third transistor (Q1A) for use as a temperature measure device; wherein said first and third transistor are emitter-coupled to form a differential amplifier and said second and fourth transistors are emitter coupled to form a differential measurement device and wherein said thermal offset control loop is coupled to said second and fourth transistors to receive a temperature dependent differential input signal.

3. A circuit according to claim 1, wherein said thermal offset control loop comprises an operational amplifier.

4. A circuit according to claim 2, wherein said first and third transistors form a second stage differential amplifier and wherein said circuit further comprises a first stage differential amplifier cascaded with said second stage differential amplifier and wherein said thermal offset control loop is connected to said first stage differential amplifier to adjust its operating point to compensate for temperature induced voltage changes at said second differential amplifier stage.

5. An integrated circuit comprising a first transistors (Q1A) for use as signal transistor and a second transistor (Q1B) integrated with said first transistor (Q1A) for use as a temperature measure device; wherein the two transistors (Q1A, Q1B) share either the same collector (C1, C2) or the same emitter (E1, E2) but have isolated base connections (B1, B2).

6. An integrated circuit according to claim 5, wherein said first and second transistors (Q1A, Q1B) are arranged within a deep trench frame of electrically isolating material.

7. An integrated circuit according to claim 5, wherein said first and second transistors (Q1A, Q1B) are of npn type and share a common collector.

8. A method for compensating temperature induce voltage changes in a signal transistor, comprising:
- providing a measurement transistor (Q1B) integrated with said signal transistor (Q1A);
- providing a voltage drop at said measurement transistor (Q1B) as input to a thermal offset control loop (OA1);
- providing a correction signal by said thermal offset control loop (OA1) to compensate a voltage change in a signal passing through said signal transistor (Q1A) for a temperature induced voltage change at said measurement transistor (Q1B).
